Europäisches Patentamt

European Patent Office

Office européen des brevets

(19)

(11) Publication number: **0 151 754 B1**

# EUROPEAN PATENT SPECIFICATION

(12)

(45) Date of publication of patent specification: **18.12.91**

(51) Int. Cl.⁵: **H01L 31/18**, H01L 31/08, C23C 16/50, H01L 31/02

(21) Application number: **84115397.6**

(22) Date of filing: **13.12.84**

(54) **An improved method of making a photoconductive member.**

(30) Priority: **14.02.84 US 580081**

(43) Date of publication of application:
**21.08.85 Bulletin 85/34**

(45) Publication of the grant of the patent:
**18.12.91 Bulletin 91/51**

(84) Designated Contracting States:
**AT BE CH DE FR GB IT LI LU NL SE**

(56) References cited:
**WO-A-81/00862       DE-A- 3 151 146**
**FR-A- 2 490 359       FR-A- 2 504 697**
**FR-A- 3 200 376       GB-A- 2 033 355**
**GB-A- 2 083 704**

(73) Proprietor: **ENERGY CONVERSION DEVICES, INC.**
**1675 West Maple Road**
**Troy Michigan 48084(US)**

(72) Inventor: **Johncock, Annette G.**
**244 South Pontiac Trail**
**Walled Lake, Michigan 48088(US)**
Inventor: **Hudgens, Stephen J.**
**2 Alexandria Town**
**Southfield Michigan 48075(US)**

(74) Representative: **Müller, Hans-Jürgen, Dipl.-Ing. et al**
**Müller, Schupfner & Gauger Maximilian-strasse 6 Postfach 10 11 61**
**W-8000 München 1(DE)**

Rank Xerox (UK) Business Services

## Description

This invention relates to a method of making photoconductive alloys and members in a commercially viable process. The process provides both a commercially viable reaction gas conversion efficiency and a commercially viable deposition rate. While forming photoconductive members from silicon based amorphous semiconductor alloys has been suggested, the methods of forming the alloys have been at a too slow deposition rate and a gas conversion efficiency which is too low for any commercial viability. The invention more particularly relates to a method of making the alloys and members by microwave plasma deposition of a selected reaction gas or gases.

Silicon is the basis of the huge crystalline semiconductor industry and is the material which has produced expensive high efficiency (18 percent) crystalline solar cells for space applications. When crystalline semiconductor technology reached a commercial state, it became the foundation of the present huge semiconductor device manufacturing industry. This was due to the ability of the scientists to grow substantially defect-free germanium and particularly silicon crystals, and then turn them into extrinsic materials with p-type and n-type conductivity regions therein. This was accomplished by diffusing into such crystalline material parts per million of donor (n) or acceptor (p) dopant materials introduced as substitutional impurities into the substantially pure crystalline materials, to increase their electrical conductivity and to control their being either of a p or n conduction type. The fabrication processes for making p-n junction crystals involve extremely complex, time consuming, and expensive procedures. Thus, these crystalline materials useful in solar cells and current control devices are produced under very carefully controlled conditions by growing individual single silicon or germanium crystals, and when p-n junctions are required, by doping such single crystals with extremely small and critical amounts of dopants.

In summary, crystal silicon devices have fixed parameters which are not variable as desired, require large amounts of material, are only producible in relatively small areas and are expensive and time consuming to produce. Devices based upon amorphous silicon can eliminate these crystal silicon disadvantages. Amorphous silicon has an optical absorption edge having properties similar to a direct gap semiconductor and only a material thickness of one micron or less is necessary to absorb the same amount of sunlight as the 50 micron thick crystalline silicon. Further, amorphous silicon can be made faster, easier and in larger areas than can crystalline silicon.

FR-A-2 490 359 describes to deposit on a substrate an amorphous photoconductive layer comprising Si, H and F and to introduce between this layer and said substrate an insulating blocking layer consisting of Si and C. On the top of these layers an amorphous cover layer comprising Si, O and N is deposited.

According to GB-A-2 033 355 such amorphous semi-conductor layers also comprising Ge are deposited in a microwave discharge in the frequency range of between 0,5 and 10 MHz. Dopants are co-deposited. According to this method the amorphous photoconductive layer is changed to form a single crystalline layer.

Accordingly, a considerable effort has been made to develop processes for readily depositing amorphous semiconductor alloys or films, each of which can encompass relatively large areas, if desired, limited only by the size of the deposition equipment, and which could be readily doped to form p-type and n-type materials where p-n junction devices are to be made therefrom equivalent to those produced by their crystalline counterparts. For many years such work was substantially unproductive. Amorphous silicon or germanium (Group IV) films are normally four-fold coordinated and were found to have microvoids and dangling bonds and other defects which produce a high density of localized states in the energy gap thereof. The presence of a high density of localized states in the energy gap of amorphous silicon semiconductor films results in a low degree of photoconductivity and short carrier lifetime, making such films unsuitable for photoresponsive applications. Additionally, such films could not be successfully doped or otherwise modified to shift the Fermi level close to the conduction or valence bands, making them unsuitable for making p-n junctions for solar cell and current control device applications.

In an attempt to minimize the aforementioned problems involved with amorphous silicon and germanium, W.E. Spear and P.G. Le Comber of Carnegie Laboratory of Physics, University of Dundee, in Dundee, Scotland, did some work on "Substitutional Doping of Amorphous Silicon", as reported in a paper published in Solid State Communications, Vol. 17, pp. 1193-1196, 1975, toward the end of reducing the localized states in the energy gap in amorphous silicon or germanium to make the same approximate more closely intrinsic crystalline silicon or germanium and or substitutionally doping the amorphous materials with suitable classic dopants, as in doping crystalline materials, to make them extrinsic and or p or n conduction types.

The reduction of the localized states was accomplished by glow discharge deposition of amorphous silicon films wherein a gas of silane ($SiH_4$) was passed through a reaction tube where the gas was decomposed by a radio frequency glow discharge and deposited on a substrate at a substrate temperature of about 500-600° K (227-327° C). The material so deposited on the substrate was an intrinsic amorphous material consisting of silicon and hydrogen. To produce a doped amorphous material a gas of phosphine ($PH_3$) for n-type conduction or a gas of diborane ($B_2H_6$) for p-type conduction were premixed with the silane gas and passed through the glow discharge reaction tube under the same operating conditions. The gaseous concentration of the dopants used was between about $5 \times 10^{-6}$ and $10^{-2}$ parts per volume. The material so deposited including supposedly substitutional phosphorus or boron dopant and was shown to be extrinsic and of n or p conduction type.

While it was not known by these researchers, it is now known by the work of others that the hydrogen in the silane combines at an optimum temperature with many of the dangling bonds of the silicon during the glow discharge deposition, to substantially reduce the density of the localized states in the energy gap toward the end of making the electronic properties of the amorphous material approximate more nearly those of the corresponding crystalline material.

The incorporation of hydrogen in the above radio frequency deposition method not only has limitations based upon the fixed ratio of hydrogen to silicon in silane, but, more importantly, various Si:H bonding configurations introduce new antibonding states which can have deleterious consequences in these materials. Therefore, there are basic limitations in reducing the density of localized states in these materials which are particularly harmful in terms of effective p doping as well as n doping. The resulting density of states of the radio frequency silane deposited materials leads to a narrow depletion width, which in turn limits the efficiencies of solar cells and other devices whose operation depends on the drift of free carriers. The radio frequency method of making these materials by the use of only silicon and hydrogen also results in a high density of surface states which affects all the above parameters.

After the development of the glow discharge deposition of silicon from silane gas was carried out, work was done on the sputter depositing of amorphous silicon films in the atmosphere of a mixture of argon (required by the sputtering deposition process) and molecular hydrogen, to determine the results of such molecular hydrogen on the characteristics of the deposited amorphous silicon film. This research indicated that the hydrogen acted as an altering agent which bonded in such a way as to reduce the localized states in the energy gap. However, the degree to which the localized states in the energy gap were reduced in the sputter deposition process was much less than that achieved by the silane deposition process described above. The above described p and n dopant gases also were introduced in the sputtering process to produce p and n doped materials. These materials had a lower doping efficiency than the materials produced in the glow discharge process. Neither process produced efficient p-doped materials with sufficiently high acceptor concentrations for producing commercial p-n or p-i-n junction devices. The n-doping efficiency was below desirable acceptable commercial levels and the p-doping was particularly undesirable since it reduced the width of the band gap and increased the number of localized states in the band gap.

Greatly improved amorphous silicon alloys having significantly reduced concentrations of localized states in the energy gaps thereof and high quality electronic properties have been prepared by glow discharge as fully described in US-A-4,226,898, and by vapor deposition as fully described in US-A 4,217,374. As disclosed in these patents, which are incorporated herein by reference, fluorine is introduced into the amorphous silicon semiconductor to substantially reduce the density of localized states therein. Activated fluorine especially readily diffuses into and bonds to the amorphous silicon in the amorphous body to substantially decrease the density of localized defect states therein, because the small size of the fluorine atoms enables them to be readily introduced into the amorphous body. The fluorine bonds to the dangling bonds of the silicon and forms what is believed to be a partially ionic stable bond with flexible bonding angles, which results in a more stable and more efficient compensation or alteration than is formed by hydrogen and other compensating or altering agents. Fluorine is considered to be a more efficient compensating or altering element than hydrogen when employed alone or with hydrogen because of its exceedingly small size, high reactivity, specificity in chemical bonding, and highest electronegativity. Hence, fluorine is qualitatively different from other halogens and so is considered a super-halogen.

As an example, compensation may be achieved with fluorine alone or in combination with hydrogen with the addition of these element(s) in very small quantities (e.g., fractions of one atomic percent). However, the amounts of fluorine and hydrogen most desirably used are much greater than such small percentages so as to form a silicon-hydrogen-fluorine alloy. Such alloying amounts of fluorine and hydrogen may, for example, be in the range of 1 to 5 percent or greater. It is believed that the new alloy so formed has a low density or defect states in the energy gap than that achieved by the mere neutralization of dangling bonds and similar defect states. Such larger amount of fluorine, in particular, is believed to participate substantially in a new structural configuration of an amorphous silicon-containing material and facilitates the addition of other alloying materials, such as germanium. Fluorine, in addition to its other characteristics mentioned herein, is believed to be an organizer of local structure in the silicon-containing alloy through inductive and ionic effects. It is believed that fluorine also influences the bonding of hydrogen by acting in a beneficial way to decrease the density of defect states which hydrogen contributes while acting as a density of states reducing element. The ionic role that fluorine plays in such an alloy is believed to be an important factor in terms of the nearest neighbor relationships.

About forty-five years ago, C. Carlson developed the first electrophotographic process based on a sulfur material. Other chalcogenides such as selenium and selenium alloys were thereafter suggested for such applications together with organic substances such as polyvinyl carbazole (PVK). These materials, however, exhibited certain deficiencies. They were toxic, and therefore difficult to handle, soft, and therefore subject to wear, and had poor infrared light photoresponse.

In view of the above noted deficiencies of these materials, silicon based amorphous semiconductor alloys were investigated for possible applications in electrophotographic processes. These materials were considered likely to be useful because of the hardness of amorphous silicon alloys, because of their nontoxic nature, and because of their improved photoresponse to infrared light. Also, as previously mentioned, these materials could be made with a density of states reduced to a point where charging of the materials to the potentials required for electrophotographic replication was considered possible. Thus, amorphous semiconductor alloys made by the processes hereinabove described have demonstrated photoresponsive characteristic which are suited for electrophotographic applications.

It has been suggested to utilize the radio frequency generated alloys in photoconductive members with a bottom and a top blocking layer. The photoconductive members need to be on the order of 15 microns thick for the members to be charged to a sufficient saturation voltage, to be practical, about 350 volts. The prior art radio frequency processes however have suffered from relatively slow deposition rates on the order of no more than 1 nm/s and low utilization of the reaction gas feed stock which are important considerations from the standpoint of making the photoconductive members from these materials on a commercial basis. If the deposition rate is increased above about 1 nm/s, such as by increasing the radio frequency power applied, then deleterious powder and/or polymers are formed and incorporated in the alloys.

Applicants herein have discovered a new and improved process for making photoconductive amorphous semiconductor alloys and members and improved device structures. The inventive process herein provides substantially increased deposition rates and reaction gas conversion efficiencies without formation of polymers or powder, so as to be commercially viable. The invention also can provide an enhanced top blocking layer and/or an improved infrared photoresponse.

The present invention provides an improved process for making photoconductive alloys and members at a commercially viable reaction gas conversion efficiency and deposition rate, substantially higher than possible in the prior art. Further, photoconductive members can be formed which have an enhanced top blocking layer and/or an improved infrared photoresponse. The members can be formed to be positively or negatively charged.

In accordance with the invention, the process includes providing a source of microwave energy, coupling the microwave energy into a substantially enclosed reaction vessel which contains a substrate onto which the photoconductive alloys are deposited. The alloys are deposited from a reaction gas which includes at least one semiconductor element to be deposited. The microwave energy and the reaction gas form a glow discharge plasma within the vessel to deposit an amorphous photoconductive semiconductor alloy from the reaction gas onto the substrate.

The reaction gas can include silane ($SiH_4$), silicon tetrafluoride ($SiF_4$), diborane ($B_2H_6$), phosphine ($PH_3$), hydrogen ($H_2$), germanium tetrafluoride ($GeF_4$) and germane ($GeH_4$) and combinations thereof. A positive charge type photoconductive member can be formed by depositing a first blocking layer onto the substrate to prevent electron injection from the substrate into the photoconductive layer. The blocking layer is formed of p-type amorphous silicon alloy with hydrogen and/or fluorine on the order of 20 to 200 nm thick. A second photoconductive layer is formed on the blocking layer of substantially intrinsic amorphous silicon alloy with hydrogen and/or fluorine on the order of 10 to 25 $\mu$m thick. A top blocking layer is formed on the photoconductive layer, which is formed of an insulating alloy to provide a high charge capability, slow dark decay and a mechanically hard surface. The top blocking layer also provides chemical resistance to moisture and temperature effects to provide the member with improved stability. The top blocking layer is formed of an alloy of silicon, hydrogen and/or fluorine and at least one of carbon, nitrogen or oxygen on the order of 50 to 1000 Angstroms thick. The top layer can be formed with the addition of oxygen ($O_2$), methane ($CH_4$), ammonia ($NH_3$) or nitrogen ($N_2$).

A negative charge type photoconductive member can be formed by depositing a first blocking layer onto the substrate to prevent hole injection from the substrate into the photoconductive layer. The blocking layer is formed of n-type amorphous silicon alloy with hydrogen and/or fluorine on the order of 20 to 200 nm thick. A second photoconductive layer is formed on the blocking layer of slightly n-type intrinsic amorphous silicon alloy with hydrogen and/or fluorine on the order of 10 to 25 $\mu$m thick. A top blocking layer is formed on the photoconductive layer of an insulating alloy to provide the previously mentioned features. The top blocking insulative alloy can be formed in the same manner as the positive charge type layer, also on the order of 5 to 100 nm thick.

A top blocking enhancement layer can be added before the top blocking layer in either the positive or negative type charge member by depositing a high quality amorphous alloy from a radio frequency glow discharge. The enhancement layer is formed of a substantially intrinsic alloy for the positive charge type members and a slightly n-type intrinsic alloy for the negative charge type members. Either type layer is formed from an amorphous alloy of silicon, hydrogen and/or fluorine on the order of a depletion width, about 100 to 400 nm, in thickness. An infrared photoresponsive layer can be added to either type member before the top blocking layer, with or without the top blocking enhancement layer. The infrared responsive layer is formed from an alloy of amorphous silicon, hydrogen and/or fluorine and a low band gap semiconductor, such as germanium, on the order of 1 $\mu$m thick.

Accordingly, a first object of the invention is to provide an improved method of forming a photoconductive member. The method provides for a substrate, a source of microwave energy, and a substantially enclosed reaction vessel. The substrate is placed into the reaction vessel while coupling microwave energy into the vessel and introducing into the vessel at least one reaction gas, which has at least one semiconductor element to be deposited, to form a plasma substrate in the vessel. The method further provides for depositing an amorphous photoconductive alloy from the reaction gas onto the substrate and is characterized by depositing the member, including depositing a first blocking layer onto the substrate, by adding at least one dopant to the reaction gas, and then depositing a second photoconductive layer onto the layer without a substantial amount of dopant therein and then depositing a third insulating blocking layer onto the photoconductive layer.

A second object of the invention is to provide an improved photoconductive member characterized by a substrate, an amorphous photoconductive alloy formed on the substrate, with substantially all of the alloy being formed by microwave plasma discharge, and an alloy which includes a photoconductive bottom blocking layer, a photoconductive layer and a top insulating blocking layer.

The preferred embodiment of this invention will now be described by way of example, with reference to the drawings accompanying this specification in which:

Fig. 1 is a perspective view, partly broken away, of a microwave plasma deposition system for depositing photoconductive amorphous semiconductor alloys and members in accordance with the process of the invention;

Fig. 2 is a fragmentary sectional view of a positive charge type embodiment of a photoconductive member to illustrate one application of the amorphous semiconductor photoreceptive alloys made by the process of the invention;

Fig. 3 is a fragmentary sectional view of a positive charge type photoconductive member which has an enhanced top blocking layer made by the process of the invention;

Fig. 4 is a fragmentary sectional view of a positive charge type photoconductive member which has an improved infrared photoresponse made by the process of the invention;

Fig. 5 is a fragmentary sectional view of a positive charge type photoconductive member having an enhanced top blocking layer and an improved infrared photoresponse made by the process of the invention;

Fig. 6 is a fragmentary sectional view of a negative charge type embodiment of a photoconductive member to illustrate one application of the amorphous semiconductor photoreceptive alloys made by the process of the invention;

Fig. 7 is a fragmentary sectional view of a negative charge type photoconductive member which has an enhanced top blocking layer made by the process of the invention;

Fig. 8 is a fragmentary sectional view of a negative charge type photoconductive member which has an improved infrared photoresponse made by the process of the invention; and

Fig. 9 is a fragmentary sectional view of a negative charge type photoconductive member having an enhanced top blocking layer and an improved infrared photoresponse made by the process of the invention.

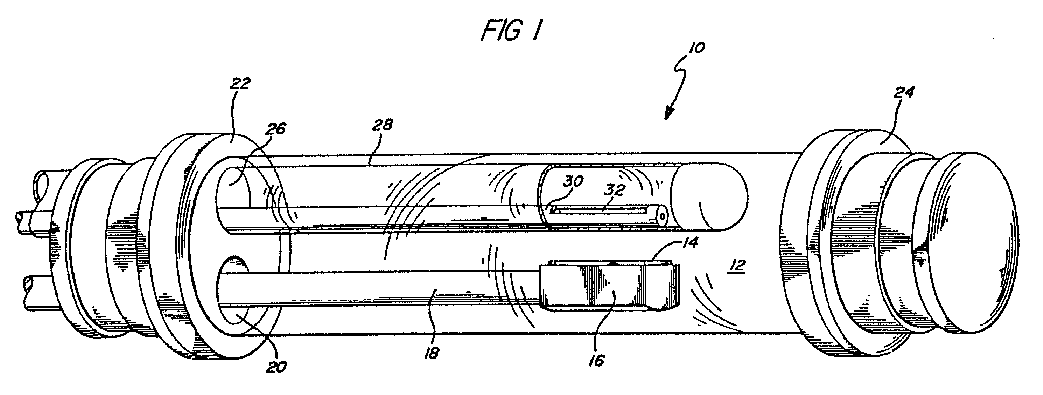

Referring now more particularly to Fig. 1, a microwave deposition apparatus suitable for practicing the process of the present invention, is generally designated 10. The apparatus 10 includes a transparent tubular chamber or reaction vessel 12 containing a substrate 14 upon which the photoconductive amorphous semiconductor alloys are to be deposited. The substrate 14 is mounted on a substrate holder 16 which is mounted on a rod or shaft 18. The substrate holder 16 can include appropriate heater and control means (not illustrated) for controlling the temperature of the substrate 14. The shaft 18 is sealingly passed through an opening 20 in an end cap 22. The opposite end of the chamber 12 is sealed by a second end cap 24. The end cap 24 serves only to seal the chamber 12, while the end cap 22 provides the opening 20 for the substrate holder 16 and openings for the introduction and evacuation of reaction gases (not shown) and an opening 26 for an antenna tube 28.

A portion of the antenna tube 28 is cut away to illustrate a microwave antenna 30 which is of a type having one of more slots 32. The slotted antenna 30 can be of the type disclosed in EPO Patent Application No. 83 306 868.7. The antenna system can also be of the type disclosed in EPO Patent Application No. 83 305 679.9.

A source of microwave energy is coupled to the antenna 30 which couples the energy into the reaction vessel 12. The combination of the reaction gases and the microwave energy from the antenna 30 causes the formation of a plasma in the area of the substrate 14, resulting in the deposition of a photoconductive alloy on the substrate. In accordance with the present invention, the reaction gases include at least one semiconductor element to form the plasma. The temperature of the substrate 14 is maintained about 300 degrees Centigrade and the frequency of the microwave energy can be 2.45 Gigahertz and above, preferably about 2.45 Gigahertz. As mentioned, the combined microwave energy and the reaction gas form the plasma to permit the deposition process to proceed.

In operation, the apparatus 10 is first pumped down to below a desired deposition pressure, such as $1{,}34 \cdot 10^{-3}$ Pa ($10^{-5}$ Torr). The reaction gases such as silicon tetrafluoride ($SiF_4$), silane ($SiH_4$), germanium tetrafluoride ($GeF_4$), germane ($GeH_4$), hydrogen ($H_2$), diborane ($B_2H_6$), phosphine ($PH_3$), oxygen ($O_2$), methane ($CH_4$), nitrogen ($N_2$), ammonia ($NH_3$) or combinations thereof, are fed into the vessel 12 through the end cap 22. A diluent, such as argon (Ar), also can be utilized, where desired. The vessel 12 is brought up to the desired operating pressure of, for example 6,7 Pa (0,05 Torr).

The microwave energy from the antenna 30 is directed into the vessel 12 to form a plasma in the area of the substrate 14. As a result, an amorphous semiconductor alloy is deposited onto the substrate 14. The heater maintains the substrate at a temperature of about 300° C. The output power of the microwave energy source is adjusted preferably to about 0,1 to 1 W/cm³ in power density. The flow rate of the reaction gases can be between 1 to 20 SCCM. With the foregoing system parameters, deposition rates of at least 10 nm/s can be obtained. Even at these high deposition rates, the deposited amorphous semiconductor films exhibit high quality photoresponsive characteristics suitable for electrophotographic applications.

One of the critical factors in making the high quality alloys at deposition rates of 10 nm/s and greater is the low operating pressure. The operating pressure of 6,7 Pa (0,05 Torr) is about an order of magnitude below a conventional radio frequency deposition pressure of 67 Pa (0,5 Torr).

Even at the deposition rate of 10 nm/s, the alloys do not contain any significant polymer or powder inclusions. Attempts to deposit these semiconductor alloys with a high radio frequency deposition rate of greater than 1 nm/s, but below even 2 nm/s, leads to very poor quality alloys with large polymer ($SiH_2n$) and/or powder inclusions.

For commercially viable photoconductive members to be manufactured, the deposition time and the amount of materials utilized must be minimized. Clearly, a deposition rate of ten times or greater than that of the radio frequency rate provides an enormous economic advantage. Further, the reaction gas conversion efficiency is also dramatically different for the microwave process of the present invention than for the prior art radio frequency deposition process. A typical radio frequency process is much less efficient in converting and depositing the reaction gas and typically converts on the order of two percent of the reaction gas into the amorphous silicon alloy. The microwave process of the present invention in dramatic contrast converts substantially one-hundred percent of the reaction gases into depositing species. This provides another enormous economic advantage in depositing the thicknesses of semiconductor alloy which are necessary to have a practical photoconductive member or device.

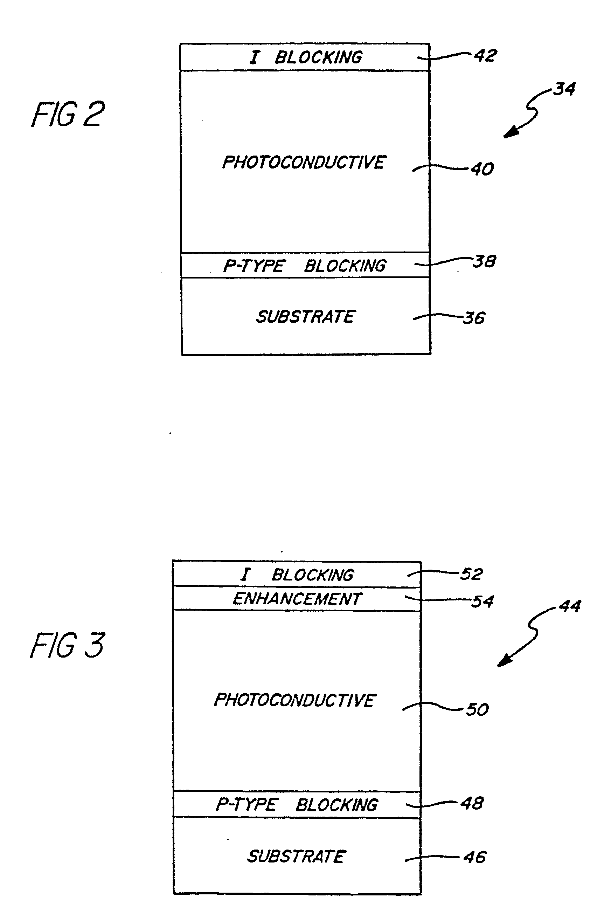

Fig. 2 illustrates a first positive charge type photoconductive member or device 34, which includes a substrate 36, a first p-type blocking layer 38, a photoconductive layer 40 and a top insulating blocking layer 42. The substrate 36 can be formed of any convenient material which is either conductive, such as a metal, or has a conductive coating formed thereon, such as glass or a polymer. The first or bottom blocking layer 38 is formed of a p-type amorphous silicon, hydrogen and/or fluorine alloy. The device 34 in such a configuration is a positively charged device and the layer 38 prevents electron injection from the substrate 36 into the photoconductive layer 40.

The blocking layer 38 preferably is formed from a reaction gas mixture of $SiH_4$ and $B_2H_6$ in $H_2$ or $SiH_4$ and/or $SiF_4$ and $B_2H_6$ in $H_2$. The blocking layer 38 is formed to create an alloy with a high p-type conductivity activation energy ($\Delta E$) of 0,2 to 0,3 eV. One preferable combination is 20 parts $SiH_4$, 5 parts $SiF_4$ and 2 parts of a mixture of 5,5 percent $B_2H_6$ in $H_2$. A second preferable combination is about 20 parts $SiH_4$ and 2 parts of a mixture of 5,5 percent $B_2H_6$ in $H_2$. The blocking layer 38 preferably is deposited with an effective power density in the range of 0,1 to 1,0 $W/cm^3$, and preferably about 0,7 $W/cm^3$. The layer blocking 38 preferably is from 20 to 200 nm thick.

The photoconductive layer 40 preferably also is deposited with an effective power density in the range of 0,1 to 1,0 $W/cm^3$, and preferably about 0,7 $W/cm^3$. The photoconductive layer 40 preferably is deposited to a thickness of 10 to 25 $\mu m$ to form an overall thickness of the alloy layers of at least 10 to 25 $\mu m$. The 10 $\mu m$ thickness is to ensure a saturation voltage of about 350 V The photoconductive alloy can sustain an electric field of up to about 35 to 40 V per micron of thickness. The photoconductive layer 40 preferably is formed from a reaction gas mixture of $SiH_4$ or $SiH_4$ and/or $SiF_4$ with a small amount of p-type dopant to form a substantially intrinsic alloy. The intrinsic alloy with no dopant is slightly n-type exhibiting a $\Delta E$ of 0,7 eV. The addition of the small amount of p-type dopant changes $\Delta E$ to about 1,0 eV. One preferable combination is 20 parts $SiH_4$, 5 parts $SiF_4$ and .5 parts of a mixture of 550 ppm of $B_2H_6$ in $H_2$. A second preferable combination is 20 parts $SiH_4$ and 0,5 parts of a mixture of 550 ppm of $B_2H_6$ in $H_2$.

The top blocking layer 42 is formed as an insulator to provide the high charging capacity of 35 to 40 $V/\mu m$ of the combined layers 38, 40 and 42. The top blocking layer 42 also provides a slow dark decay on the order of less than fifteen percent in one second and a very hard surface as compared to any chalcogenide, for example Se or $Se_{92}Te_8$. The top blocking layer 42 is chemically resistant to moisture and temperature effects to provide the member with improved stability. The layer has a band gap of greater than 3,0 Ev. The top blocking layer 42 preferably is formed from a reaction gas mixture of $SiH_4$ or $SiH_4$ and/or $SiF_4$ and at least one of oxygen, carbon or nitrogen. One preferable combination is 22 parts $CH_4$ and 10 parts $SiH_4$. A second preferable combination is 22 parts $CH_4$, 10 parts $SiH_4$ and 10 parts $SiF_4$. An oxide blocking layer of $SiO_2$ can be formed from 1 part $H_2$ and 5 parts of 5 percent $O_2$ in $SiF_4$. The oxide layer can be deposited at a power density of

.34 watts per cubic centimeter, and a substrate temperature of 350° C at about 4,8 nm/s. A nitride blocking layer also can be formed from $N_2$ and $SiH_4$ or $NH_3$ and $SiH_4$. The top blocking layer 42 is deposited at a power density in the range of 0,2 to 1,2 $W/cm^3$ cubic centimeter and preferably is from 5 to 100 thick.

The first blocking layer 38 and the photoconductive layer 40 are deposited at 10 nm/s or greater, which, as mentioned above, is at least ten times the deposition rate of prior art methods. Approximately eighty percent of the reaction gas can be utilized which is also significantly greater than the prior art utilization percentage of about two percent. The top insulative blocking layer 42 is deposited at a somewhat slower rate of about 3 nm/s which is still much greater than the radio frequency deposition rate of the prior art.

Fig. 3 illustrates another positive charge type photoconductive member embodiment 44 which has an enhanced top blocking layer. A substrate 46, a bottom p-type blocking layer 48, a photoconductive layer 50 and a top blocking layer 52 are provided which are essentially the same as the similarly described layers in Fig. 2. An enhanced top blocking layer 54 is deposited before the blocking layer 52. Although the microwave deposition provides a high quality alloy layer, it can contain more defects because of the high deposition rate than a properly deposited radio frequency layer. The enhanced top blocking layer 54 is then deposited by a conventional radio frequency plasma to provide a high quality layer with a density of states which is lower than the microwave deposited photoconductive layer 50. The radio frequency layer 54 enhances the blocking layer 52, because the lower density of states provides greater band bending and thus better charge retention. The effective overall deposition rate and reaction gas utilization is not lowered too significantly, since the enhanced blocking layer 54 preferably is on the order of a depletion width thick, generally 100 to 400 nm. The enhanced blocking layer 54 can be deposited from the same reaction gas mixture as the photoconductive layer 50.

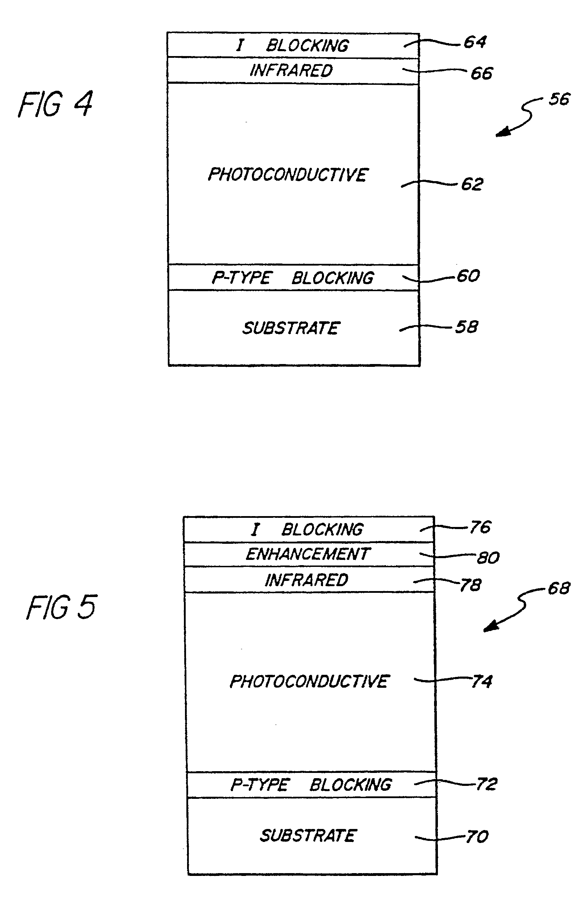

Fig. 4 illustrates a positive charge type photoconductive member or device 56 which has an improved infrared photoresponse. A substrate 58, a bottom blocking layer 60, a photoconductive layer 62 and a top insulating blocking layer 64 are provided which are essentially the same as the similarly described layers in Fig. 2. The improved infrared photoresponse is provided by a low band gap layer 66. The photoconductive layer 62 generally has a band gap in the range of 1,7 to 1,8 eV, which is suitable for most photoresponsive applications, however, it is not low enough for infrared applications, such as laser line printers. A laser line printer can be operated with a diode GaAs laser at about 840 nm. The low band gap infrared layer 66 can be formed from a reaction gas mixture and process which can be the same as that described in depositing the layer 40 with the addition of a low band gap semiconductor element, such as germanium. Germanium can be added to the gas mixture in the form of germane ($GeH_4$) or germanium tetrafluoride ($GeF_4$). The low band gap infrared layer 66 can be formed about 10,000 Angstroms thick with a band gap of about 1,5 eV. The low band gap infrared layer 66 can be formed from a reaction gas mixture of 1 part $GeH_4$, 5 parts $SiF_4$ and 3 parts $H_2$. The layer can be deposited with an effective power density in the range of 0,1 to 1,0 $W/cm^3$ and preferably at a power density of 0,34 $W/cm^3$ at about 1,3 nm/s with a substrate temperature of 275°C. The lower band gap provides an additional response in the infrared frequencies. For utilization of the photoconductive members with light which is predominantly of wavelengths shorter than the infrared range, the low band gap infrared layer 66 has less utility and can be eliminated.

The low band gap infrared layer 66 also can be deposited by a conventional radio frequency plasma to provide both the enhanced top blocking layer provided by the layer 54 and the infrared photoresponse.

Fig. 5 illustrates a positive charge type photoconductive member or device 68 which has both an enhanced top blocking layer and an improved infrared photoresponse. A substrate 70, a bottom blocking layer 72, a photoconductive layer 74 and a top blocking layer 76 are provided and are essentially the same as the similarly described layers in Fig. 2. A microwave deposited low band gap infrared layer 78 is provided with a top blocking enhancement layer 80, which are essentially the same as the similarly described layers in Figs. 4 and 3, respectively.

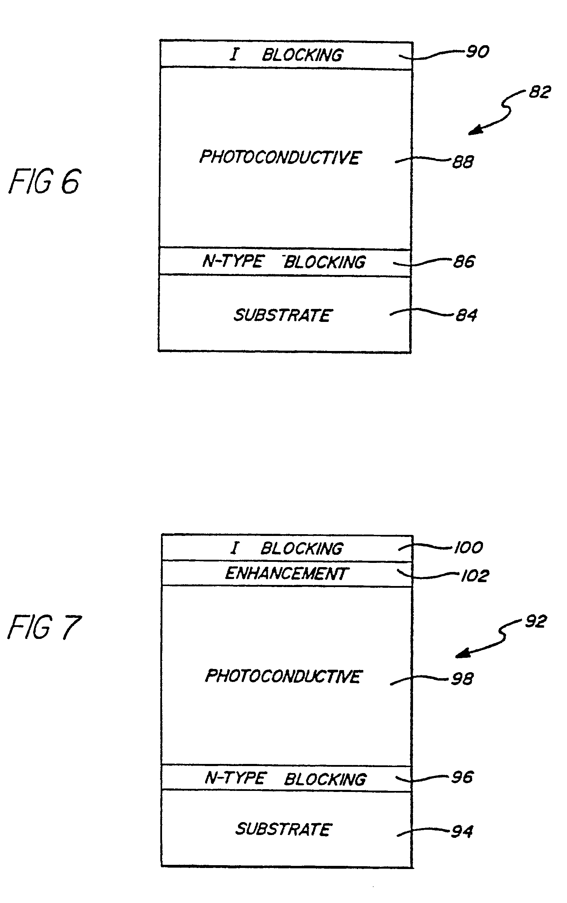

Although some conventional photoconductive members, such as Se based drums, are positive charge type devices, the amorphous photoconductive alloy members of the present invention are particularly suitable to be utilized as negative charge type devices, as well. The product of the electron mobility and tau, the electron recombination lifetime, of these alloys is greater in the undoped alloy material than that of the holes and thus unlike the chalcogenide based systems, these alloys can operate in either the positive or negative charge type configurations. Figs. 6-9 are directed to negative charge type devices or members.

Fig. 6 illustrates a first negative charge type photoconductive member or device 82, which includes a substrate 84, a first n-type blocking layer 86, a photoconductive layer 88 and a top insulative blocking layer 90. The substrate 84 again can be formed of any convenient material which is either conductive, such as a metal, or has a conductive coating formed thereon, such as glass or a polymer. The first or bottom blocking layer 86 is formed of an n-type amorphous silicon, hydrogen and/or fluorine alloy. The device 82 in such a configuration is a negatively charged device and the n-type blocking layer 86 prevents hole injection from the substrate 84 into the photoconductive layer 88.

The n-type blocking layer 86 preferably is formed from a reaction gas mixture of $SiH_4$ and $PH_3$ in $H_2$ or $SiH_4$ and/or $SiF_4$ and $PH_3$ in $H_2$. One preferable combination is 20 parts $SiH_4$, 5 parts $SiF_4$ and 2 parts of a mixture of 5,5 percent $PH_3$ in $H_2$. A second preferable combination is about 20 parts $SiH_4$ and 2 parts of a mixture of 5,5 percent $PH_3$ in $H_2$. The blocking layer 86 preferably is deposited with an effective power density in the range of 0,1 to 1,0 $W/cm^3$, and preferably about 0,7 $W/cm^3$. The blocking layer 86 preferably is from 20 to 200 nm thick with a high n-type $\Delta E$ of 0,2 to 0,3 eV.

The photoconductive layer 88 preferably also is deposited with an effective power density in the range of 0,1 to 1,0 $W/cm^3$ and preferably about 0,7 $W/cm^3$. The photoconductive layer 88 preferably is deposited to a thickness of from 10 to 25 $\mu m$ to form an overall thickness of the alloy layers of at least 10 to 25 $\mu m$. The 10 $\mu m$ thickness is to ensure a saturation voltage of at least 350 V. The alloy can sustain an electric field of up to about 35 to 40 $V/\mu m$ of thickness. The photoconductive layer 88 preferably is formed from a reaction gas mixture of $SiH_4$ or $SiH_4$ and/or $SiF_4$ to form an intrinsic alloy with a $\Delta E$ of about 0,7-0,9 eV (the intrinsic alloy is slightly n-type). One preferable combination is 20 parts $SiH_4$ and 5 parts $SiF_4$. A second preferable combination is 20 parts $SiH_4$.

The top blocking layer 90 is formed as an insulator to provide the high charging capacity of 35 to 40 $V/\mu m$ of thickness of the combined layers 86, 88 and 90. The top blocking layer 90 also provides a slow dark decay on the order of less than fifteen percent in one second and a very hard surface as compared to any chalcogenide, for example Se or $Se_{92}Te_8$. The top blocking layer 90 again is chemically resistant to provide an improved member stability and has a band gap greater than 3,0 eV. The top blocking layer 90 can be formed as an insulator from a reaction gas mixture of $SiH_4$ or $SiH_4$ and/or $SiF_4$ and at least one of oxygen, carbon or nitrogen. One preferable combination is 22 parts $CH_4$ and 10 parts $SiH_4$. A second preferable combination is 22 parts $CH_4$, 10 parts $SiH_4$ and 10 parts $SiF_4$. An oxide blocking layer of $SiO_2$ can be formed from 1 part $H_2$ and 5 parts of 5 percent $O_2$ in $SiF_4$. The oxide layer can be deposited with a power density of about .34 watts per cubic centimeter, a substrate temperature of 350°C at about 48 4,8 nm/s. A nitride blocking layer also can be formed from $N_2$ and $SiH_4$ or $NH_3$ and $SiH_4$. The top blocking layer 90 is deposited at an effective power density in the range of 0,1 to 1,0 $W/cm^3$ and preferably is 5 to 100 nm thick.

The n-type blocking layer 86 and the photoconductive layer 88 are again deposited at 10 nm/s or greater, which as mentioned above is at least ten times the deposition rate of prior art methods. Again, approximately eighty percent of the reaction gas can be utilized which is also significantly greater than the prior art utilization percentage of approximately two percent. The top blocking layer 90 is deposited at a somewhat slower rate of about 3 nm/s which is still much greater than the radio frequency deposition rate of the prior art.

Fig. 7 illustrates another negative charge type photoconductive member embodiment 92 which has an enhanced top blocking layer, similar to the member 68 (See Fig. 5). A substrate 94, a bottom n-type blocking layer 96, a photoconductive layer 98 and a top insulative blocking layer 100 are provided which are essentially the same as the similarly described layers in Fig. 6. An enhanced top blocking layer 102 is deposited before the top insulative blocking layer 100. As described above, although the microwave deposition provides a high quality alloy layer, it can contain more defects because of the high deposition rate than a properly deposited radio frequency layer. The enhanced blocking layer 102 is then deposited by a conventional radio frequency plasma to provide a high quality layer with a density of states which is lower than the microwave deposited photoconductive layer 98. The radio frequency enhanced layer 102 enhances the top insulative blocking layer 100, because the lower density of states provides greater band bending and better charge retention. The effective overall deposition rate and reaction gas utilization is not lowered too significantly, since the enhanced layer 102 preferably is on the order of a depletion width thick, generally 100 to 400 nm. The enhanced top blocking layer 102 can be deposited from the same reaction gas mixture as the photoconductive layer 98.

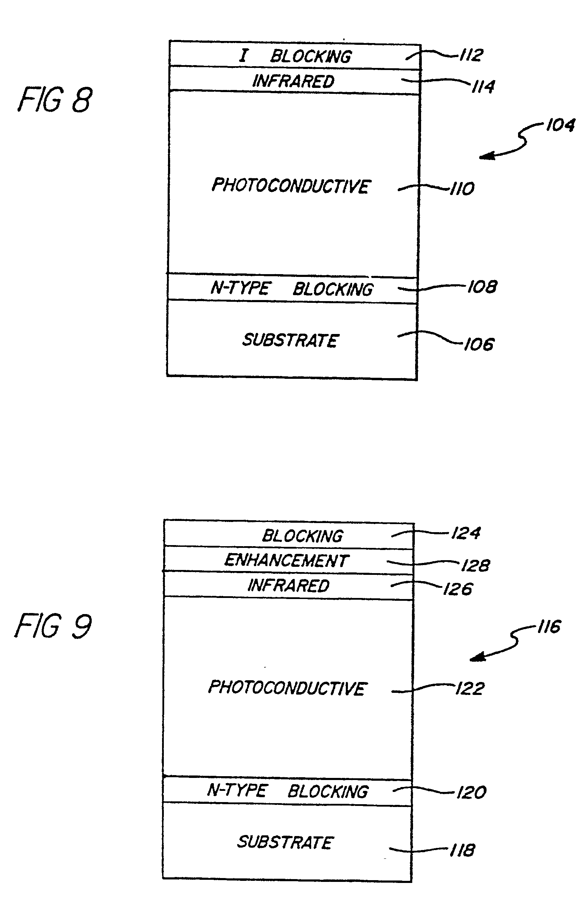

Fig. 8 illustrates a negative charge type photoconductive member or device 104 which has an improved infrared photoresponse. A substrate 106, a bottom blocking layer 108, a photoconductive layer 110 and a top insulative blocking layer 112 are provided which are essentially the same as the similarly described layers in Fig. 6. The improved infrared photoresponse is provided by a low band gap layer 114. The photoconductive layer 110, again generally has a band gap in the range of 1,7 to 1,8 eV, which is suitable for most photoresponsive applications, however, it is not low enough for IR applications, such as laser line printers. A laser line printer can be operated with a diode GaAs laser at about 840 nm. The low band gap layer 114 can be formed from a reaction gas mixture and process which can be the same as that described in depositing the photoconductive layer 88 (See Fig. 6) with the addition of a low band gap semiconductor element, such as germanium.

Germanium can be added to the gas mixture in the form of germane ($GeH_4$) or germanium tetrafluoride ($GeF_4$). The low band gap layer 114 can be formed about 1 μm thick with a band gap of about 1,5 eV. The low band gap layer 114 can be formed from a reaction gas mixture of 1 part $GeH_4$, 5 parts $SiF_4$ and 3 parts $H_2$. The layer can be deposited at a power density of .34 watts per cubic centimeter at about 1,3 nm/s with a substrate temperature of 275°C. The lower band gap provides an additional response in the infrared frequencies. For utilization of the photoconductive members with light which is predominantly of wavelengths shorter than the infrared range, the low band gap layer 114 has less utility and can be eliminated.

The low band gap layer 114 also can be deposited by a convention radio frequency plasma to provide both the enhanced top blocking layer provided by the enhanced layer 102 (See Fig. 7) and the improved infrared photoresponse.

Fig. 9 illustrates a negative charge type photoconductive member or device 116 which has both an enhanced top blocking layer and an improved infrared photoresponse. A substrate 118, an n-type bottom blocking layer 120, a photoconductive layer 122 and a top insulative blocking layer 124 are provided and are essentially the same as the similarly described layers in Fig. 6. A microwave deposited low band gap infrared layer 126 is followed by a top blocking enhancement layer 128, which are essentially the same as the similarly described layers in Figs. 8 and 7, respectively.

Modifications and variations of the present invention are possible in light of the above teachings. While a planar stationary substrate 14 has been described in Fig. 1, the photoconductive members can also be deposited on a drumshaped substrate when desired. The rod or shaft 18 then can be rotated to coat the outside of the drum or cylinder. The bottom blocking layers do not have to be amorphous and can be, for example, polycrystalline. (By the term "amorphous" is meant an alloy or material which has long range disorder, although it may have short or intermediate order or even contain at times some crystalline inclusions.) It is therefore, to be understood that within the scope of the appended claims the invention may be practiced otherwise than as specifically described.

## Claims

1. Method of forming a photoconductive member by providing a substrate (14, 36, 46, 50, 70, 84, 94, 106, 118), a source of microwave energy, and a substantially enclosed reaction vessel (12) and placing said substrate into said vessel; coupling said microwave energy into said vessel; and introducing into said vessel at least one reaction gas, including at least one semi-conductor element to be deposited, to form a plasma discharge in said vessel and to deposit an amorphous photoconductive alloy from said reaction gas onto said substrate, **characterized** in that
a first blocking layer (38, 48, 60, 72, 86, 96, 108, 120)is deposited onto said substrate, by adding at least one dopant to said reaction gas;
a second photoconductive layer (40, 50, 62, 74, 88, 98, 110, 122) is deposited onto said first blocking layer without a substantial amount of dopant therein;
and then a third insulating blocking layer (42, 52, 64, 76, 90, 100, 112, 124, 128) is deposited onto said second photoconductive layer by adding a precursor gaseous source of carbon, nitrogen or oxygen to the reaction gas and subjecting said gaseous mixture to said microwave energy.

2. Method according to claims 1 further characterized in that said reaction gas contains at least silicon.

3. Method according to claim 1 or 2 further characterized in that said reaction gas contains at least fluorine.

4. Method according to any of the preceding claims further characterized by depositing said blocking layer (38, 48, 60, 72, 86, 96, 108, 120) and/or said photoconductive layer (40, 50, 62, 74, 88, 98, 110, 122) at a deposition rate of at least 10 nm/s at an operating pressure of less than 13,4 Pa (0,1 Torr).

5. Method according to any of the preceding claims further characterized by depositing said insulating blocking layer (42, 52, 64, 76, 90, 100, 112, 124, 128) at a deposition rate of at least 3 nm/s.

6. Method according to claim 5 further characterized by depositing an enhancement layer (54, 66, 80, 102, 114, 126) from a mixture including silicon and hydrogen and/or fluorine, onto said second layer (50, 62, 74, 98, 110, 122) before said third blocking layer (52, 64, 76, 90, 100, 112, 124) by providing and coupling radio frequency energy into said reaction vessel.

7. Method acording to any of the preceding claims further characterized by depositing an infrared photoresponsive layer (126) onto said second layer (122) before said insulating layer (124) by adding a germanium-containing gas to said reaction gases, and depositing an enhancement layer (128) onto said infrared photoresponsive layer (126) by providing and coupling radio frequency energy into said reaction vessel.

8. Method according to claim 6 or 7 further characterized by depositing said third insulating blocking layer (52, 64, 76, 90, 100, 112, 124, 128) onto said enhancement layer (54, 66, 80, 102, 114, 124) by adding at least one carbon-, nitrogen- or oxygen containing gas reaction gas and again coupling said microwave energy into said vessel.

## Revendications

1. Procédé de fabrication d'un élément photoconducteur en utilisant un substrat (14, 36, 46, 50, 70, 84, 94, 106, 118), une source d'énergie à micro-onde et une cuve à réaction (12) pratiquement fermée et en plaçant ledit substrat à l'intérieur de ladite cuve ; en couplant ladite énergie à micro-onde à l'intérieur de ladite cuve ; et en introduisant dans ladite cuve au moins un gaz réactionnel, comprenant au moins un élément semi-conducteur à déposer, pour former à l'intérieur de ladite cuve une décharge sous plasma et déposer un alliage photoconducteur amorphe à partir desdits gaz réactionnels sur ledit substrat, caractérisé en ce qu'une première couche de blocage (38, 48, 60, 72, 86, 96, 108, 120) est déposée sur ledit substrat, en ajoutant au moins un dopant auxdits gaz réactionnels ; une seconde couche photoconductrice (40, 50, 62, 74, 88, 98, 110, 122) est déposée sur ladite première couche de blocage sans contenir une quantité substantielle de dopant ; et ensuite une troisième couche de blocage isolante (42, 52, 64, 76, 90, 100, 112, 124 128) est déposée sur ladite seconde couche photoconductrice en ajoutant une source gazeuse préalable de carbone, d'azote ou d'oxygène aux gaz réactionnels et en soumettant ledit mélange gazeux à ladite énergie à micro-onde.

2. Procédé selon la revendication 1, caractérisé en outre en ce que lesdits gaz réactionnels contiennent au moins du silicium.

3. Procédé selon la revendication 1 ou 2, caractérisé en outre en ce que lesdits gaz réactionnels contiennent au moins du fluor.

4. Procédé selon l'une quelconque des revendications précédentes, caractérisé en outre par le dépôt de ladite couche de blocage (38, 48, 60, 72, 86, 96, 108, 120) et/ou ladite couche photoconductrice (40, 50, 62, 74, 88, 98, 110, 122) à une vitesse de dépôt d'au moins 10 nm/s sous une pression utile de moins de 13,4 Pa (0,1 Torr).

5. Procédé selon l'une quelconque des revendications précédentes, caractérisé en outre par le dépôt de ladite couche de blocage isolante (42, 52, 64, 76, 90, 100, 112, 124, 128) à une vitesse de dépôt d'au moins 3 nm/s.

6. Procédé selon la revendication 5, caractérisé en outre par le dépôt d'une couche de renforcement (54, 66, 80, 102, 114, 126) à partir d'un mélange contenant du silicium et de l'hydrogène et/ou du fluor sur ladite seconde couche (50, 62, 74, 98, 110, 122) avant ladite troisième couche de blocage (52, 64, 76, 90, 100, 112, 124) en appliquant et en couplant de l'énergie à radiofréquence à l'intérieur de ladite cuve à réaction.

7. Procédé selon l'une quelconque des revendications précédentes, caractérisé en outre par le dépôt d'une couche photosensible à l'infrarouge (126) sur ladite seconde couche (122) avant ladite couche isolante (124) en ajoutant un gaz contenant du germanium auxdits gaz réactionnels, et en déposant une couche de renforcement (128) sur ladite couche photosensible à l'infrarouge (126) en appliquant et en couplant de l'énergie à radiofréquence à l'intérieur de ladite cuve à réaction.

8. Procédé selon la revendication 6 ou 7, caractérisé en outre par le dépôt de ladite troisième couche de blocage (52, 64, 76, 90, 100, 112, 124, 128) sur ladite couche de renforcement (54, 66, 80, 102, 114, 124) et par l'addition d'au moins un gaz contenant du carbone, de l'azote ou de l'oxygène auxdits gaz réactionnels et en couplant encore ladite énergie à micro-onde à l'intérieur de ladite cuve.

**Patentansprüche**

1. Verfahren zur Bildung eines fotoleitenden Elements durch Bereitstellen eines Substrats (14, 36, 46, 50, 70, 84, 94, 106, 118), einer Mikrowellenenergiequelle und eines im wesentlichen geschlossenen Reaktionsbehälters (12) und Anordnen des Substrats in dem Behälter; Einkoppeln der Mikrowellenenergie in den Behälter; und Einleiten wenigstens eines Reaktionsgases in den Behälter, wobei das Reaktionsgas wenigstens ein abzuscheidendes Halbleiterelement enthält, unter Erzeugung einer Plasmaentladung in dem Behälter und Abscheidung einer amorphen fotoleitenden Legierung aus dem Reaktionsgas auf das Substrat, **dadurch gekennzeichnet,** daß auf dem Substrat eine erste Sperrschicht (38, 48, 60, 72, 86, 96, 108, 120) abgeschieden wird unter Zugabe von wenigstens einem Dotierungsstoff zu dem Reaktionsgas; daß auf der ersten Sperrschicht eine fotoleitende zweite Schicht (40, 50, 62, 74, 88, 98, 110, 122) ohne einen wesentlichen Anteil von Dotierungsstoff abgeschieden wird; und daß dann auf der fotoleitenden zweiten Schicht eine dritte, isolierende Sperrschicht (42, 52, 64, 76, 90, 100, 112, 124, 128) unter Zugabe einer gasförmigen Vorstufenquelle von Kohlenstoff, Stickstoff oder Sauerstoff zu dem Reaktionsgas und Aussetzen dieses gasförmigen Gemischs der Mikrowellenenergie abgeschieden wird.

2. Verfahren nach Anspruch 1, **dadurch gekennzeichnet,** daß das Reaktionsgas wenigstens Silicium enthält.

3. Verfahren nach Anspruch 1 oder 2, **dadurch gekennzeichnet,** daß das Reaktionsgas wenigstens Fluor enthält.

4. Verfahren nach einem der vorhergehenden Ansprüche, **gekennzeichnet durch** Abscheiden der Sperrschicht (38, 48, 60, 72, 86, 96, 108, 120) und/oder der fotoleitenden Schicht (40, 50, 62, 74, 88, 98, 110, 122) mit einer Abscheidungsrate von wenigstens 10 nm/s bei einem Betriebsdruck von weniger als 13,4 Pa (0,1 Torr).

5. Verfahren nach einem der vorhergehenden Ansprüche, **gekennzeichnet durch** Abscheiden der isolierenden Sperrschicht (42, 52, 64, 76, 90, 100, 112, 124, 128) mit einer Abscheidungsrate von wenigstens 3 nm/s.

6. Verfahren nach Anspruch 5,
**gekennzeichnet durch**
Abscheiden einer Verstärkungsschicht (54, 66, 80, 102, 114, 126) aus einem Silicium und Wasserstoff und/oder Fluor enthaltenden Gemisch auf die zweite Schicht (50, 62, 74, 98, 110, 122) vor der dritten Sperrschicht (52, 64, 76, 90, 100, 112, 124) durch Bereitstellen und Einkoppeln von HF-Energie in den Reaktionsbehälter.

7. Verfahren nach einem der vorhergehenden Ansprüche,
**gekennzeichnet durch**
Abscheiden einer IR-lichtempfindlichen Schicht (126) auf der zweiten Schicht (122) vor der Isolierschicht (124) durch Zugabe eines germaniumhaltigen Gases zu den Reaktionsgasen, und Abscheiden einer Verstärkungsschicht (128) auf der IR-lichtempfindlichen Schicht (126) durch Bereitstellen und Einkoppeln von HF-Energie in den Reaktionsbehälter.

8. Verfahren nach Anspruch 6 oder 7,
**gekennzeichnet durch**
Abscheiden der dritten isolierenden Sperrschicht (52, 64, 76, 90, 100, 112, 124, 128) auf die Verstärkungsschicht (54, 66, 80, 102, 114, 124) durch Zugabe eines wenigstens entweder Kohlenstoff, Stickstoff oder Sauerstoff enthaltenden Gases zu dem Reaktionsgas und erneutes Einkoppeln der Mikrowellenenergie in den Reaktionsbehälter.

EP 0 151 754 B1

FIG 1

FIG 2

| I BLOCKING | —42 |
|---|---|
| PHOTOCONDUCTIVE | —40 |
| P-TYPE BLOCKING | —38 |
| SUBSTRATE | —36 |

34

FIG 3

| I BLOCKING | —52 |
|---|---|
| ENHANCEMENT | —54 |
| PHOTOCONDUCTIVE | —50 |
| P-TYPE BLOCKING | —48 |
| SUBSTRATE | —46 |

44

FIG 4

| I BLOCKING | — 64 |
| INFRARED | — 66 |
| PHOTOCONDUCTIVE | — 62 |
| P-TYPE BLOCKING | — 60 |
| SUBSTRATE | — 58 |

— 56

FIG 5

| I BLOCKING | — 76 |
| ENHANCEMENT | — 80 |
| INFRARED | — 78 |
| PHOTOCONDUCTIVE | — 74 |
| P-TYPE BLOCKING | — 72 |
| SUBSTRATE | — 70 |

— 68

*FIG 6*

| I BLOCKING | ~90 |
|---|---|
| PHOTOCONDUCTIVE | ~88 |
| N-TYPE BLOCKING | ~86 |
| SUBSTRATE | ~84 |

82

*FIG 7*

| I BLOCKING | ~100 |
|---|---|
| ENHANCEMENT | ~102 |
| PHOTOCONDUCTIVE | ~98 |
| N-TYPE BLOCKING | ~96 |
| SUBSTRATE | ~94 |

92

FIG 8

| I BLOCKING | ~112 |
| INFRARED | ~114 |
| PHOTOCONDUCTIVE | ~110 |
| N-TYPE BLOCKING | ~108 |
| SUBSTRATE | ~106 |

*104*

FIG 9

| BLOCKING | ~124 |
| ENHANCEMENT | ~128 |
| INFRARED | ~126 |
| PHOTOCONDUCTIVE | ~122 |
| N-TYPE BLOCKING | ~120 |
| SUBSTRATE | ~118 |

*116*